(19) Europäisches Patentamt
European Patent Office
Office européen des brevets

(11) **EP 2 885 835 B1**

(12) **FASCICULE DE BREVET EUROPEEN**

(45) Date de publication et mention de la délivrance du brevet:
**20.07.2016 Bulletin 2016/29**

(21) Numéro de dépôt: **13756342.5**

(22) Date de dépôt: **19.08.2013**

(51) Int Cl.:
*H01M 10/052* (2010.01)     *H01M 14/00* (2006.01)
*H01L 31/053* (2014.01)     *H01M 4/38* (2006.01)
*H01M 4/485* (2010.01)     *H01M 4/505* (2010.01)
*H01M 4/525* (2010.01)     *H01M 4/58* (2006.01)

(86) Numéro de dépôt international:
**PCT/EP2013/067247**

(87) Numéro de publication internationale:
**WO 2014/029741 (27.02.2014 Gazette 2014/09)**

(54) **CELLULE D'ACCUMULATEUR PHOTOVOLTAÏQUE**

PHOTOVOLTAISCHE BATTERIEZELLE

PHOTOVOLTAIC BATTERY CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.08.2012 FR 1257891**

(43) Date de publication de la demande:
**24.06.2015 Bulletin 2015/26**

(73) Titulaire: **Commissariat à l'Énergie Atomique et aux Énergies Alternatives
75015 Paris (FR)**

(72) Inventeur: **MARTIN, Steve
38160 Saint Sauveur (FR)**

(74) Mandataire: **Brevalex
95, rue d'Amsterdam
75378 Paris Cedex 8 (FR)**

(56) Documents cités:
**JP-A- H10 208 782          US-A- 4 916 035
US-A1- 2009 072 780**

- **KANBARA T ET AL: "Photo-rechargeable solid state battery", SOLID STATE IONICS, NORTH HOLLAND PUB. COMPANY. AMSTERDAM; NL, NL, vol. 40-41, 1 août 1990 (1990-08-01), pages 955-958, XP025834307, ISSN: 0167-2738, DOI: 10.1016/0167-2738(90)90161-J [extrait le 1990-08-01]**
- **LICHT S ET AL: "Light invariant, efficient, multiple band gap AlGaAs/Si/metal hydride solar cell", APPLIED PHYSICS LETTERS, AIP, AMERICAN INSTITUTE OF PHYSICS, MELVILLE, NY, US, vol. 74, no. 26, 28 juin 1999 (1999-06-28), pages 4055-4057, XP012023035, ISSN: 0003-6951, DOI: 10.1063/1.123259**

**Description**

**DOMAINE TECHNIQUE**

L'invention se rapporte au domaine du stockage de l'énergie, et plus particulièrement des dispositifs de stockage d'énergie dotés d'au moins une cellule d'accumulateur couplée à une cellule photovoltaïque.

**ETAT DE LA TECHNIQUE ANTERIEURE**

Les performances en termes de stockage en énergie électrique d'un dispositif formé de cellules photovoltaïques dépendent fortement de l'état d'ensoleillement du milieu dans lequel ce dispositif est placé.

Ce type de dispositif a pour inconvénient de ne pas permettre de fournir de l'énergie la nuit et d'alimenter des systèmes nécessitant de forts pics de puissance.

Pour pallier ce problème, il est connu d'associer des moyens de stockage d'énergie de type accumulateur aux cellules photovoltaïques, les accumulateurs étant rechargés par les cellules photovoltaïques lorsque l'énergie lumineuse est suffisante.

Le document US 2003/0127126 A1 divulgue par exemple un dispositif dans lequel une cellule solaire et une cellule d'accumulateur sont couplées.

Il est également connu du document WO 2009/032986 de prévoir un dispositif dans lequel une cellule solaire et une cellule électrochimique d'accumulateur sont connectées entre elles et co-intégrées sur un même support.

Le document US 4481265 divulgue un autre dispositif à cellule photovoltaïque et cellule d'accumulateur co-intégrées, la cellule photovoltaïque étant réalisée sur une première face d'un substrat, tandis que la cellule d'accumulateur électrochimique est disposée sur une deuxième face du substrat opposée à la première face.

Le document US 2009/072780 présente une structure permettant à la fois de réaliser une conversion d'énergie lumineuse en énergie électrique et de mettre en oeuvre un stockage d'énergie électrique.

Il se pose le problème de mettre en oeuvre un dispositif de stockage d'énergie amélioré doté d'une cellule d'accumulateur électrochimique couplée à une cellule photovoltaïque.

**EXPOSÉ DE L'INVENTION**

La présente invention concerne tout d'abord, selon la revendication 1, un dispositif de conversion d'énergie lumineuse en énergie électrique et de stockage d'énergie électrique comprenant au moins une cellule d'accumulateur électrochimique, ladite cellule étant formée d'un electrolyte disposé entre une première électrode et une deuxième électrode, la deuxième électrode comprenant une couche à base de matériau semi-conducteur comportant une zone adaptée pour convertir des photons en électrons.

La cellule mise en oeuvre suivant l'invention joue ainsi à la fois le rôle de cellule d'accumulateur électrochimique et de cellule photovoltaïque.

Ainsi, on met en oeuvre un dispositif permettant de produire de l'énergie électrique à partir d'énergie lumineuse et de stocker cette énergie électrique tout en limitant son encombrement.

Ladite zone de la couche de matériau semi-conducteur peut comprendre une jonction PN.

Cette zone comporte une première région dopée par des ions d'une espèce d'ions destinée à être échangée entre la première électrode et la deuxième électrode.

La zone de ladite couche de matériau semi-conducteur adaptée pour convertir des photons en électrons comporte une deuxième région dopée en regard de ladite première région dopée et formant une jonction avec ladite région dopée.

Dans le cas où ladite cellule est une cellule d'accumulateur au lithium, ladite première région est dopée par des ions Li+.

Un dopage de première région avec l'espèce d'ions destinée à être échangée entre les électrodes de la cellule permet notamment d'obtenir un bon contrôle du niveau de dopage et d'obtenir une cellule avec un niveau de dopage ajustable.

Un tel dopage peut avoir été réalisé par diffusion en déposant une couche de Lithium sur la couche de matériau semi-conducteur ou lors de la charge de la cellule.

Selon une possibilité de mise en oeuvre, la couche de matériau semi-conducteur comporte une face appelée « face avant » sur laquelle repose l'électrolyte et qui est en contact avec une troisième région dopée, cette troisième région dopée ayant un dopage de même type que celui de la première région dopée et une concentration en dopants supérieure à celle de la première région dopée, et étant disposée entre ladite face avant et ladite première région dopée.

Cette troisième région dopée permet d'améliorer la prise de contact sur la face avant de la deuxième électrode, en particulier avec un circuit extérieur ou des moyens adaptés pour mettre en oeuvre une décharge de la cellule d'accumulateur.

La couche de matériau semi-conducteur comporte une face arrière, opposée à ladite face avant, et qui est destinée à être exposée à un rayonnement lumineux. En fonction de la répartition des matériaux et en particulier des couches dopées, l'éclairement peut être fait par la face avant ou par la face arrière.

Selon un mode de réalisation, cette face arrière peut être en contact avec une quatrième région dopée disposée entre ladite face arrière et ladite deuxième région dopée, la quatrième région dopée ayant un dopage de même type que celui de la deuxième région dopée et une concentration en dopants supérieure à celle de la deuxième région dopée.

Cette quatrième région dopée permet d'améliorer la prise de contact sur la deuxième électrode, en particulier avec un circuit extérieur ou des moyens adaptés pour mettre en oeuvre une charge de la cellule d'accumulateur.

La cellule peut comprendre une première zone de prise de contact sur une face avant de ladite couche à base de matériau semi-conducteur sur laquelle repose l'électrolyte, et une deuxième zone de prise de contact sur une face arrière de ladite couche à base de matériau semi-conducteur destinée à être exposée à un rayonnement lumineux.

Selon une possibilité de mise en oeuvre, la face arrière de la couche à base de matériau semi-conducteur peut comporter un élément métallique ajouré, ladite deuxième zone de prise de contact étant une zone dudit élément métallique ajouré.

Cet élément métallique ajouré peut être sous forme par exemple d'un peigne.

Selon une possibilité de mise en oeuvre, ledit matériau semi-conducteur peut comporter un adjuvant tel que du carbone pour favoriser la conduction électrique dans ledit matériau semi-conducteur.

Le dispositif peut comprendre en outre un circuit comportant :

- des moyens pour permettre la charge de la cellule d'accumulateur,
- des moyens pour permettre la décharge de la cellule d'accumulateur,
- des moyens pour placer alternativement la cellule dans un état de charge ou dans un état de décharge.

Selon un autre aspect, l'invention concerne, selon la revendication 10, un procédé de réalisation d'une cellule d'accumulateur électrochimique comprenant la formation d'une électrode de la cellule à base de matériau semi-conducteur et de moyens dans ledit matériau semi-conducteur de cette électrode pour convertir des photons en électrons.

Ces moyens pour convertir des photons en électrons peuvent être formés d'au moins une jonction PN réalisée dans ledit matériau semi-conducteur.

La réalisation des moyens pour convertir des photons en électrons comporte une étape de dopage d'une région dudit matériau semi-conducteur à l'aide d'ions d'une espèce d'ions destinés à circuler entre les électrodes de la cellule d'accumulateur.

Cela permet notamment de réduire le nombre d'étapes mises en oeuvre pour réaliser la cellule.

Dans le cas d'un accumulateur au Lithium, le dopage peut être un dopage à l'aide d'ions Li+.

Selon une possibilité de mise en oeuvre du procédé, ce dopage peut être réalisé par :

- dépôt d'une couche de Lithium,
- recuit thermique de manière à faire diffuser des ions Li+ dans ledit matériau semi-conducteur.

Selon une autre possibilité de mise en oeuvre du procédé, ce dopage peut être réalisé par :

- polarisation d'une autre électrode de la cellule, de manière à insérer des ions Li+ en provenance de ladite autre électrode dans ledit matériau semi-conducteur, puis modifications successives de ladite polarisation de manière à dés insérer puis insérer à nouveau des ions Li+ du matériau semi-conducteur.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un principe général de mise en oeuvre d'un dispositif suivant l'invention doté d'une cellule jouant à la fois le rôle d'accumulateur électrochimique et de cellule photovoltaïque,
- les figures 2A-2D illustrent un principe de fonctionnement d'un dispositif suivant l'invention,
- la figure 3 illustre un exemple particulier de mise en oeuvre d'un dispositif suivant l'invention,
- la figure 4 illustre un autre exemple particulier de mise en oeuvre d'un dispositif suivant l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

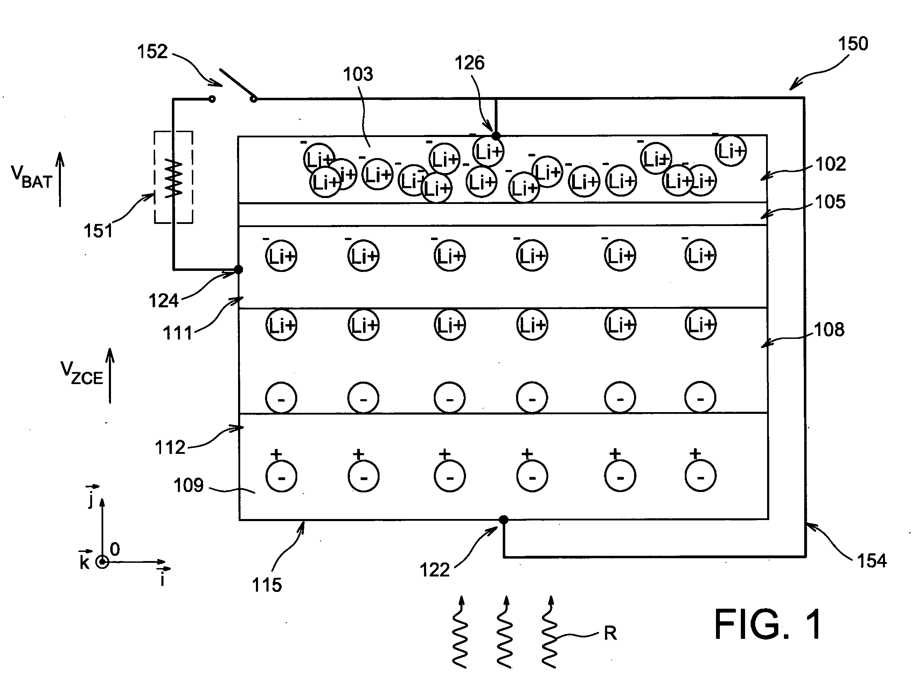

Un exemple de dispositif doté d'une cellule d'accumulateur électrochimique formant également une cellule photovoltaïque est illustré sur la figure 1.

Cette cellule peut être réalisée à l'aide d'un empilement de couches minces et comprend une première électrode 102 et une deuxième électrode 108 disposées de part et d'autre d'un électrolyte 105.

La première électrode 102 peut être formée d'au moins une première couche active 103 à base d'un matériau conducteur ionique et électronique, apte à contenir au moins une espèce d'ions et d'autre part à libérer et/ou accepter cette espèce d'ions.

La cellule peut être une cellule d'accumulateur au Lithium. Dans ce cas, les ions destinés à circuler entre les électrodes 102 et 108 sont des ions Li+.

Le matériau de la première couche active 103 peut être choisi en fonction du matériau à base duquel la deuxième électrode 108 est réalisée. Le matériau de la première couche 103 peut être prévu de manière à présenter un potentiel d'insertion vis-à-vis de ladite espèce d'ions, par exemple des ions Li+, supérieur ou égal à celui de la deuxième électrode 108.

Dans le cas notamment où la deuxième électrode 108 est réalisée à base de silicium, la première couche active 103 formant la première électrode 102, peut être par exemple à base de l'un ou l'autre des matériaux suivants : $V_2O_5$, $LiCoO_2$, $LiF_ePO_4$, $TiS_2$, $TiOS$, $TiO_2$, $Nb_2O_5$, $LiMn_2O_4$, $Li_4Ti_5O_{12}$, $FeS_2$.

On peut également prévoir la première première électrode 102 et la deuxième électrode 108 à base de silicium.

Selon une possibilité de réalisation, un adjuvant peut être ajouté au matériau de la première électrode 102 pour en améliorer la conductivité ionique et/ou électronique. Cet adjuvant peut être par exemple du carbone pour améliorer la conductivité électronique de la première électrode 102.

La deuxième électrode 108 peut, quant à elle, être formée d'une deuxième couche active 109 à base d'un matériau apte à contenir ladite espèce d'ions et d'autre part à libérer et/ou accepter ladite espèce d'ions, par exemple des ions Li+.

La deuxième électrode 108 joue également le rôle de zone photovoltaïque permettant d'absorber des photons et de convertir des photons en électrons. La deuxième électrode 108 est à base d'un matériau semi-conducteur et comprend des régions dopées 111, 112 formant au moins une jonction.

La couche active 109 de matériau semi-conducteur comprend une région 111 dopée ou susceptible d'être dopée par des ions appartenant à ladite espèce d'ions destinés à traverser l'électrolyte 105. Cela permet un bon contrôle, par diffusion électrochimique, du niveau de dopage dans la région 111.

Cela permet également de mettre en oeuvre une cellule photovoltaïque avec un niveau de dopage ajustable.

Dans le cas où l'on met en oeuvre une cellule d'accumulateur au lithium, le matériau semi-conducteur peut comprendre une région 111 dopée N à l'aide d'ions Li+. Le matériau semi-conducteur peut être par exemple du germanium, du silicium ou de l'arséniure de gallium.

L'épaisseur de la deuxième couche active 109 dépend des propriétés d'absorption optiques de son matériau. Ces dernières dépendent de la nature chimique ainsi que des propriétés morphologiques du matériau d'électrode.

Par exemple, dans le cas d'une deuxième couche active 109 à base de silicium mono- ou poly-cristallin, une épaisseur de plusieurs centaines de micromètres typiquement de l'ordre de 100 $\mu$m peut être prévue pour former la deuxième électrode 108.

Dans le cas où la couche active 109 est à base d'un matériau semi-conducteur amorphe, cette dernière peut avoir une épaisseur de plusieurs centaines de nanomètres, par exemple de l'ordre de 500 nm.

Les performances en termes de conversion photovoltaïque de la couche active 109 dépendent notamment de son profil de dopage, et en particulier du profil de dopage de la région dopée par ladite espèce d'ions destinée à circuler dans la cellule, par exemple des ions lithium.

Le dopage de la deuxième couche active 109 en ions Lithium peut être obtenu au moins partiellement, par voie électrochimique, c'est-à-dire, une fois que l'empilement de couches formant la cellule a été réalisé, en faisant fonctionner cette cellule en accumulateur, et en mettant en oeuvre une succession de charges et de décharges de la cellule d'accumulateur.

Pour effectuer une lithiation par voie électrochimique, on peut procéder par exemple à un cyclage galvano-statique c'est à dire à courant constant appliqué entre des contacts 122 et 124 illustrés sur la figure 1, l'intensité du courant étant comprise par exemple entre 100 nA et 1 mA, par exemple de l'ordre de 10 $\mu$A.

Le dopage de la deuxième couche active 109 peut être en variante réalisé par une étape intermédiaire de diffusion consistant à déposer une couche de matériau contenant du lithium sur la couche active 109, puis à effectuer un recuit ou traitement thermique.

Pour cette variante on peut par exemple déposer sur la couche active 109 une couche de lithium d'épaisseur comprise par exemple entre 10 nm et 50 $\mu$m, puis effectuer un recuit thermique à une température qui peut être prévue inférieure à 600°C.

Avantageusement, la première couche active 103 peut être à base d'un matériau prévu de sorte qu'une différence de potentiel électrochimique avec le matériau de la deuxième électrode est sensiblement égale à ou proche de la valeur d'un potentiel de zone de charge d'espace typiquement de l'ordre de 0,7 V.

Pour cela, on peut prévoir par exemple la première couche active 103 à base de Si et la couche active 109 à base de Ge, ou la première couche active 103 à base de Si et la couche active 109 à base de Sn.

Un électrolyte 105 sépare la première électrode 102 de la deuxième électrode 108. Cet électrolyte 105 peut contenir un liquide ou être sous forme solide ou bien de gel. L'électrolyte 105 peut être sous forme d'une couche ou d'un empilement de couches de matériau conducteur ionique et isolant électronique, par exemple un verre de composition : $Li_{2,9}PO_{3,3}N_{0,46}$ communément appelé « Lipon® ».

L'épaisseur de l'électrolyte 105 est choisie de manière à rendre étanche celui-ci au passage des électrons, mais suffisamment faible pour ne pas opposer une résistance trop importante au passage des ions.

L'épaisseur de la couche 105 d'électrolyte peut être par exemple comprise entre 100 nm et 3000 nm et par exemple de l'ordre de 2 micromètres.

L'électrolyte 105 peut être formé à l'aide d'une technique de pulvérisation à l'aide d'un magnétron à partir d'une cible, par exemple une cible de $Li_3PO_4$ lorsque cet électrolyte est de type « Lipon® ».

Dans le cas d'un électrolyte 105 sous forme liquide, celui-ci peut être par exemple de type LiPF$_6$ et comprendre une membrane d'imprégnation.

La membrane d'imprégnation peut être par exemple du polypropylène non tissé. Une membrane séparatrice microporeuse en polypropylène peut être également employée. Une telle membrane permet d'éviter la formation de dendrites.

Un circuit comprenant des moyens de gestion de l'énergie électrique stockée par la cellule peut être prévu.

La cellule peut être connectée à un circuit 150 comprenant une charge 151 susceptible d'être connectée à la première électrode 102 par l'intermédiaire d'un interrupteur 152 lorsque la cellule d'accumulateur est mise dans un état de décharge de son énergie électrique.

Le circuit 150 peut comprendre un étage de recharge 154 connectant la première électrode 102 et la deuxième électrode 108 pour permettre de recharger la cellule d'accumulateur.

Une première zone de prise de contact 124 peut être prévue sur la deuxième électrode 108. Cette zone de prise de contact 124 peut-être formée par un dopage élevé d'une région de la couche active 109 ou par l'ajout (non représenté sur cette figure) d'une ou plusieurs zones métalliques de collecte d'électrons afin par exemple de relier la deuxième électrode 108 à la charge 151.

Une autre zone de prise de contact 122 peut être également prévue sur une autre zone de la deuxième électrode 108 afin par exemple de relier cette dernière à l'étage de recharge 154.

Une troisième zone de prise de contact 126 peut être prévue sur la première électrode 102 afin de relier cette dernière à l'étage de recharge 154 et à l'interrupteur 152 du circuit 150.

Le premier contact 122 et le troisième contact 126 peuvent être reliés ensemble par le biais d'un élément conducteur, qui peut être par exemple sous forme d'un fil métallique de connexion ou d'une zone de connexion communément appelée « via » traversant l'empilement de couches et formée par exemple d'une colle conductrice.

Selon une autre possibilité, la connexion entre le premier contact 122 et le troisième contact 126 peut être établie au moyen d'une piste conductrice déposées par exemple par une technique de dépôt sous vide de type PECVD (« Plasma Enhanced Chemical Vapor Deposition ») ou PVD (« physical vapor deposition ») ou de dispense d'encre.

Selon une possibilité de mise en oeuvre (non représentée) de la cellule, pour améliorer le piégeage de photons, la face extérieure 115 de la deuxième couche active 109, destinée à être exposée à un rayonnement lumineux R peut être structurée ou recouverte d'une ou plusieurs couches antireflet.

Une ou plusieurs couches anti-reflet peuvent être également prévues sur la face appelée « face arrière » de la deuxième électrode 108 qui est destinée à être illuminée.

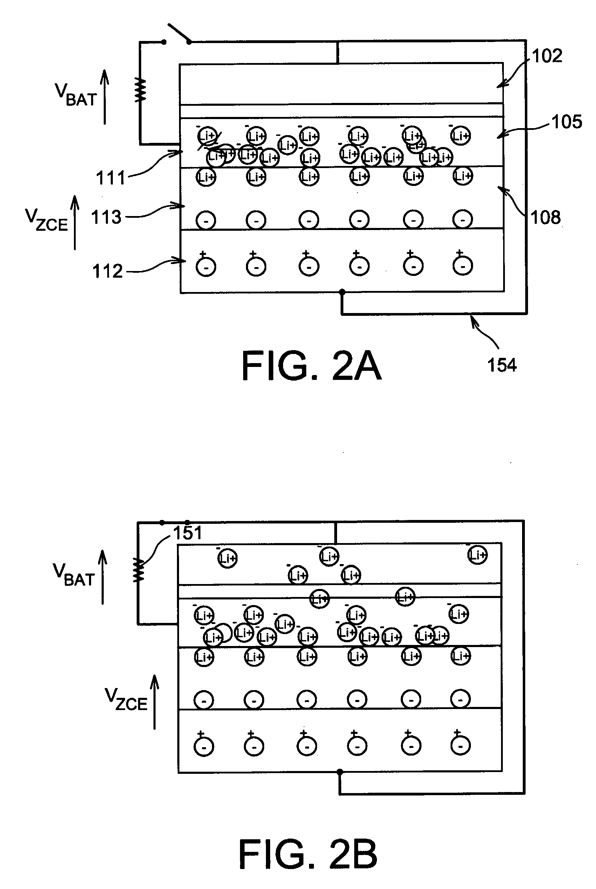

Un mode de fonctionnement d'une cellule suivant l'invention jouant à la fois le rôle d'accumulateur et de cellule photovoltaïque, va à présent être décrit en liaison avec les figures 2A-2D, dans le cas où les ions échangés entre les électrodes 102 et 108 et servant à doper le matériau semi-conducteur de la deuxième couche active 109 sont des ions Li+.

Sur la figure 2A, la cellule d'accumulateur est représentée à l'état chargé. La majorité des ions Li+ se trouve alors dans la deuxième électrode 108. La présence en forte concentration de ces ions Li+ dans la deuxième électrode 108, modifie la nature du dopage de cette dernière dans une zone située au voisinage de l'électrolyte 105.

La présence d'une région 111 dopée N dans une zone de la deuxième électrode 108 située à proximité de l'électrolyte 105 et d'une région 112 dopée P dans une autre zone située à proximité de la face arrière de la deuxième électrode destinée à être exposée à un rayonnement lumineux engendre l'apparition d'une zone de charge d'espace 113. La présence d'un champ électrique dans cette zone de charge d'espace empêche les électrons de passer de la deuxième électrode 108 vers la première électrode 102 à travers l'élément de circuit 154.

Lorsque qu'une charge 151 est connectée au circuit 150 (figure 2B), des électrons quittent la deuxième électrode 108 pour rejoindre la première électrode 102 en alimentant la charge 151. Les ions Li+ stockés dans la deuxième électrode 108 migrent vers la première électrode 102 en passant par l'électrolyte 105, de sorte que la cellule d'accumulateur se décharge.

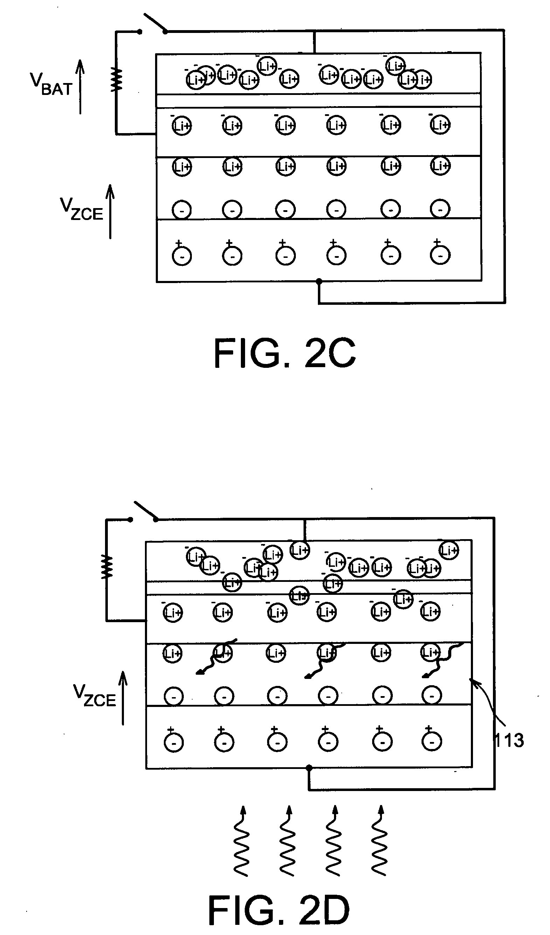

Sur la figure 2C, un état déchargé est illustré. Dans cet état, la majorité des ions lithium se situe dans la première électrode 102.

Lorsque la cellule est exposée à un rayonnement lumineux, une absorbtion de photons par la deuxième couche active 109, engendre une génération de paires électron-trou (figure 2D). Un champ électrique au sein de la zone de charge d'espace 113 a pour effet de séparer les charges. Les électrons migrent alors vers une zone de la deuxième électrode 108 à proximité de l'électrolyte 105, tandis que les trous migrent dans une direction opposée. Des ions lithium présents dans la première électrode 102 au voisinage de l'interface avec l'électrolyte 105 migrent à travers l'électrolyte 105 en direction de la deuxième électrode 108, de manière à maintenir la neutralité électrique. Ainsi, une recharge de la cellule d'accumulateur s'opère.

La capacité théorique C$_{th}$ de la deuxième électrode 108 dans laquelle la zone d'absorption photovoltaïque est formée peut être prévue au moins 5 fois supérieure à la capacité fonctionnelle C$_f$ de la cellule d'accumulateur et de préférence au moins 100 fois plus élevée. Une telle condition permet d'empêcher le matériau semi-conducteur de la couche active 109 d'être dégénéré et d'altérer les propriétés photovoltaïques de la deuxième électrode 108. Par capacité fonctionnelle C$_f$ on entend la capacité maximum que la batterie peut délivrer sous un régime de 1C. Une estimation d'une valeur maximum de cette capacité fonctionnelle $C_f$ peut être obtenue en calculant la quantité globale de lithium présente dans la structure et en considérant une capacité volumique de ce matériau de 206 $\mu Ah/cm^2$.m. En variante, cette capacité fonctionnelle peut être mesurée lors de la décharge de la structure à un régime de 1C.

Par capacité théorique $C_{th}$ on entend une quantité d'énergie théorique maximum que la deuxième électrode 108 est capable de stocker, cette valeur pouvant être obtenue par le calcul suivant :

$$C_{th} = Cv * S * e$$

avec :

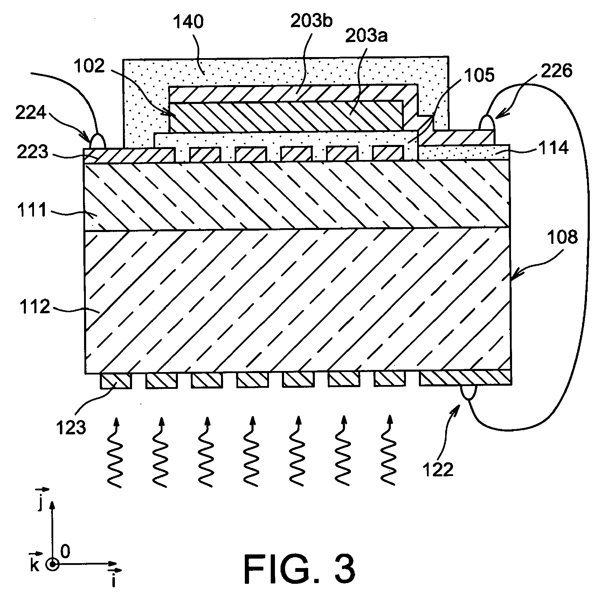

- Cv = Capacité théorique volumique de l'électrode qui peut être par exemple 834 $\mu Ah/cm^2$ pour le silicium vis-à-vis du lithium dans la phase $Li_{15}Si_4$,
- S = la surface de la deuxième électrode 108 (c'est-à-dire la surface de la deuxième électrode 108 mesurée dans un plan parallèle au plan [O; $\vec{i}$ ; $\vec{k}$] sur le repère orthogonal [O; $\vec{i}$ ; $\vec{j}$ ; $\vec{k}$] donné sur la figure 3),
- e = l'épaisseur totale de la deuxième électrode 108 (mesurée dans une direction parallèle au vecteur $\vec{j}$ du repère orthogonal [O; $\vec{i}$ ; $\vec{d}$ ; $\vec{k}$]).

Un exemple particulier de réalisation d'une cellule photovoltaïque formant également une cellule d'accumulateur est illustré sur la figure 3.

Dans cet exemple, la cellule comporte en outre une couche d'encapsulation 140 qui peut être à base de résine époxy et recouvre la première électrode 102. Cette couche d'encapsulation 140 peut servir de barrière à l'humidité.

La première électrode 102 comprend une couche active 203a qui peut être par exemple à base $Li_{15}Si_4$ et peut avoir une épaisseur par exemple de l'ordre de 1 $\mu$m. La première électrode 102 peut également avoir une surface par exemple de l'ordre de 5 $cm^2$ (mesurée dans un plan parallèle au plan [O; $\vec{i}$ ; $\vec{k}$] sur le repère orthogonal [O; $\vec{i}$ ; $\vec{j}$ ; $\vec{k}$] donné sur la figure 3).

L'électrode 102 comprend dans cet exemple une autre couche 203b, par exemple à base de Titane, servant de collecteur, et qui recouvre la couche active 203a de l'électrode 102 et comporte une portion dévoilée, qui forme une zone de prise de contact 226.

Cette zone de prise de contact 226 est isolée de la deuxième électrode 108 par l'intermédiaire d'une couche de matériau diélectrique par exemple de type $SiO_2$ et d'épaisseur de 300 nm.

La deuxième électrode 108 est quant à elle formée par exemple de silicium mono-cristallin, et comporte une région 111 dopée N par des ions Li+, ainsi qu'une région 112 dopée P. Le silicium mono-cristallin de la deuxième électrode 108 peut avoir une résistivité par exemple de l'ordre de 22 $\Omega$.m. La deuxième électrode 108 a une épaisseur par exemple de l'ordre de 100 $\mu$m.

L'électrolyte 105 prévue entre la première électrode 102 et la deuxième électrode 108 est par exemple de type LiPON et d'épaisseur de l'ordre de 1 $\mu$m.

Dans cet exemple particulier une zone de prise de contact 122 peut être réalisée sur une zone métallique 123 ajourée, par exemple sous forme d'un peigne en aluminium, formée sur la face arrière de la deuxième électrode 108, c'est-à-dire la face que l'on expose à un rayonnement lumineux. Des ouvertures entre les dents du peigne permettent de laisser passer la lumière, tandis que les dents permettent d'assurer une collecte d'électrons en surface du matériau semi-conducteur de l'électrode 108.

Une autre zone de prise de contact 224 peut être réalisée sur une zone 223 métallique ajourée, par exemple sous forme d'un peigne à base de Ti, disposée sur la face avant de la deuxième électrode 108 opposée à la face arrière exposée au rayonnement lumineux.

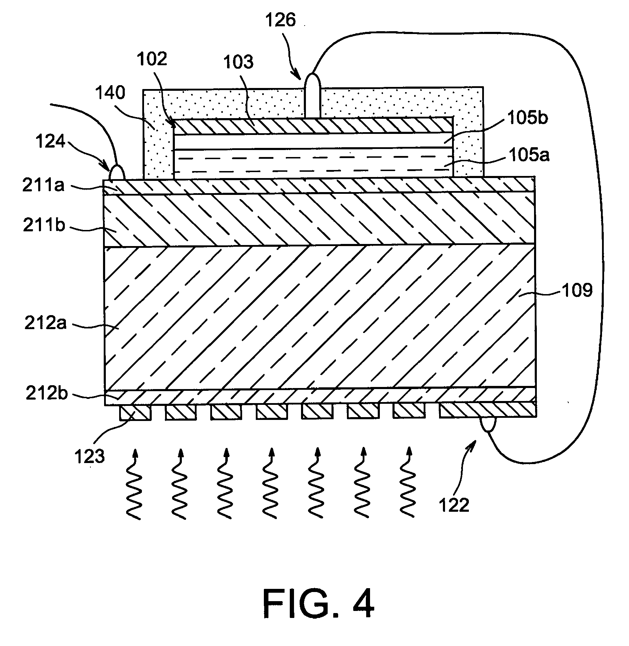

Un autre exemple particulier de réalisation d'une cellule d'accumulateur formant un dispositif jouant à la fois le rôle de cellule photovoltaïque et d'accumulateur est illustré sur la figure 4.

Cet exemple diffère de celui précédemment décrit notamment de par l'électrolyte 105 disposée entre les électrodes 102, 108. Dans cet exemple, l'électrolyte 105 comprend une solution liquide, par exemple formée de $LiPF_6$ et d'un mélange équimolaire de carbonate d'éthylène et de carbonate de diéthylène imprégnant une première membrane 105a par exemple en polypropylène non tissé.

Cette première membrane 105a est surmontée d'une deuxième membrane 105b par exemple en polypropylène. La deuxième membrane 105b est elle-même surmontée de la première électrode 102 par exemple sous forme d'une couche active 103 à base de $LiCoO_2$ d'épaisseur 50 $\mu$m sur laquelle une zone de prise contact 126 peut être réalisée. Cette zone prise de contact 126 traverse une couche d'encapsulation 140 formant un capot hermétique et recouvrant la première électrode 102 ainsi que des zones latérales de l'électrolyte 105.

La deuxième électrode 108 peut quant à elle être formée par exemple de silicium polycristallin de type P dopé au bore, et épaisseur par exemple de l'ordre de 300 $\mu$m. La deuxième électrode 108 comporte une région 211a dopée N, par exemple fortement dopée au phosphore en contact avec la face avant de la deuxième électrode 102. Cette région 211a, également en contact avec l'électrolyte 105 peut permettre de remplacer le peigne métallique de l'exemple de réalisation précédemment donné sur la figure 3. Une zone de prise de contact 124 peut être réalisée sur la région 211a, qui est également accolée à, et surmonte, une région 211b dopée N par le biais d'ions Li+.

La deuxième électrode 108 comporte également une région 212a dopée P, par exemple dopée au bore, accolée à la région 211b ainsi qu'une région 212b fortement dopée P, par exemple dopée au bore, accolée à la face arrière de la deuxième électrode 108, c'est-à-dire la face de la deuxième électrode 108 destinée à recevoir un rayonnement lumineux. Cette face arrière peut être recouverte d'une zone métallique, par exemple sous forme d'un peigne 123 en aluminium sur laquelle une zone de prise de contact 122 est réalisée.

**Revendications**

1. Dispositif de conversion d'énergie lumineuse en énergie électrique et de stockage d'énergie électrique comprenant au moins une cellule d'accumulateur électrochimique, ladite cellule étant formée :

   - d'une première électrode (102) et d'une deuxième électrode (108), une espèce donnée d'ions étant destinée à circuler entre lesdites électrodes lors d'une charge ou d'une décharge de la cellule,
   - d'un électrolyte (105) disposé entre la première électrode et la deuxième électrode (108), la deuxième électrode (108) comprenant une couche (109) à base de matériau semi-conducteur comportant une zone adaptée pour convertir des photons en électrons, ladite couche (109) de matériau semi-conducteur comportant une première région (111, 211b) dopée par des ions de ladite espèce donnée d'ions.

2. Dispositif selon la revendication 1, dans lequel la cellule est une cellule d'accumulateur au lithium, ladite première région (111, 211b) étant dopée par des ions Li+.

3. Dispositif selon la revendication 1 ou 2, ladite couche (109) de matériau semi-conducteur comportant une deuxième région (112, 212a) dopée en regard de ladite première région dopée et formant une jonction avec ladite région dopée.

4. Dispositif selon la revendication 3, dans lequel ladite couche (109) de matériau semi-conducteur comporte une face avant sur laquelle repose l'électrolyte (105), ladite face avant étant en contact avec une troisième région dopée (211a) disposée entre ladite face avant et ladite première région dopée (211b), ladite troisième région dopée (211a) ayant un dopage de même type que celui de la première région dopée (211b) et une concentration en dopants supérieure à celle de ladite première région dopée (211b).

5. Dispositif selon la revendication 3 ou 4, dans lequel ladite couche (109) de matériau semi-conducteur comporte une face arrière destinée à être exposée à un rayonnement lumineux et qui est opposée à une face avant sur laquelle repose l'électrolyte (105), ladite face arrière étant en contact avec une quatrième région dopée (212b) disposée entre ladite face arrière et ladite deuxième région dopée (212a), ladite quatrième région dopée (212b) ayant un dopage de même type que celui de la deuxième région dopée (212a) et une concentration en dopants supérieure à celle de la deuxième région dopée (212a).

6. Dispositif selon l'une des revendications 1 à 5, dans lequel la cellule comprend une première zone de prise de contact (124, 224) sur une face avant de ladite couche (109) à base de matériau semi-conducteur sur laquelle repose l'électrolyte, et une deuxième zone de prise de contact (122) sur une face arrière de ladite couche (109) à base de matériau semi-conducteur destinée à être exposée à un rayonnement lumineux.

7. Dispositif selon la revendication 6, dans lequel ladite couche de matériau semi-conducteur comporte une face arrière sur laquelle repose un élément métallique ajouré, ladite deuxième zone de prise de contact étant une zone dudit élément métallique ajouré.

8. Dispositif selon l'une des revendications 1 à 7, dans lequel la cellule comprend une zone de prise de contact (226) sur une portion de la première électrode (102) isolée de la deuxième électrode par l'intermédiaire d'une couche (114) de matériau diélectrique.

9. Dispositif selon l'une des revendications 1 à 8, comprenant en outre un circuit doté:

   - de moyens pour favoriser la charge de la cellule d'accumulateur,
   - de moyens pour favoriser la décharge de la cellule d'accumulateur,
   - de moyens pour placer alternativement la cellule dans un état de charge ou de décharge,

10. Procédé de réalisation d'une cellule d'accumulateur électrochimique comprenant la formation d'une électrode de la cellule à base de matériau semi-conducteur destinée à libérer et/ou accepter au moins une espèce d'ions et de moyens dans ledit matériau semi-conducteur de cette électrode pour convertir des photons en électrons, la réalisation desdits moyens pour convertir des photons en électrons comportant le dopage d'une région dudit matériau semi-conducteur par des ions de ladite espèce d'ions.

11. Procédé selon la revendication 10, ledit dopage étant réalisé à l'aide d'ions Li+.

12. Procédé selon la revendication 11, ledit dopage étant réalisé par :

     - dépôt d'une couche de Lithium,
     - recuit thermique de manière à faire diffuser des ions Li+ dans ledit matériau semi-conducteur.

**13.** Procédé selon la revendication 12, ledit dopage à l'aide d'ions Li+ dudit matériau semi-conducteur comprenant des étapes consistant à placer de manière répétée la cellule d'accumulateur dans un état de charge et dans un état de décharge.


**Patentansprüche**

**1.** Vorrichtung zur Umwandlung von Strahlungsenergie in elektrische Energie und zum Speichern von elektrischer Energie, umfassend wenigstens eine elektrochemische Akkumulatorzelle, welche Zelle gebildet ist aus:

     - einer ersten Elektrode (102) und einer zweiten Elektrode (108), wobei ein gegebener Typ von Ionen dazu bestimmt ist, zwischen den Elektroden während eines Ladens oder eines Entladens der Zelle zu zirkulieren,
     - einem Elektrolyten (105), welcher zwischen der ersten Elektrode und der zweiten Elektrode (108) angeordnet ist, wobei die zweite Elektrode (108) eine Schicht (109) auf Grundlage eines Halbleiter-Materials umfasst, welche einen Bereich umfasst, welcher dazu eingerichtet ist, Photonen in Elektronen umzuwandeln, wobei die Schicht (109) aus Halbleiter-Material eine erste Region (111, 211 b) umfasst, welche mit Ionen von dem gegebenen Typ von Ionen dotiert ist.

**2.** Vorrichtung nach Anspruch 1, wobei die Zelle eine Lithium-Akkumulatorzelle ist, wobei die erste Region (111, 211b) mit Li+-Ionen dotiert ist.

**3.** Vorrichtung nach Anspruch 1 oder 2, wobei die Schicht (109) aus Halbleiter-Material eine zweite Region (112, 212a) umfasst, welche verglichen mit der ersten dotierten Region dotiert ist und einen Übergang mit der dotierten Region bildet.

**4.** Vorrichtung nach Anspruch 3, wobei die Schicht (109) aus Halbleiter-Material eine vordere Fläche umfasst, auf welcher sich das Elektrolyt (105) befindet, wobei die vordere Fläche mit einer dritten dotierten Region (211 a) in Kontakt ist, welche zwischen der vorderen Fläche und der ersten dotierten Region (211b) angeordnet ist, wobei die dritte dotierte Region (211 a) eine Dotierung vom selben Typ wie die erste dotierte Region (211b) aufweist, sowie eine Konzentration an Dotierungsmaterialien, welche größer ist als diejenige der ersten dotierten Region (211 b).

**5.** Vorrichtung nach Anspruch 3 oder 4, wobei die Schicht (109) aus Halbleiter-Material eine hintere Fläche umfasst, welche dazu vorgesehen ist, einer Lichtstrahlung ausgesetzt zu werden, und welche einer vorderen Fläche gegenüberliegt, auf welcher sich das Elektrolyt (105) befindet, wobei die hintere Fläche mit einer vierten dotierten Region (212b) in Kontakt ist, welche zwischen der hinteren Fläche und der zweiten dotierten Region (212a) angeordnet ist, wobei die vierte dotierte Region (212b) eine Dotierung vom gleichen Typ aufweist wie diejenige der zweiten dotierten Region (212a), sowie eine Konzentration an Dotierungsmaterialien, welche größer ist als diejenige der zweiten dotierten Region (212a).

**6.** Vorrichtung nach einem der Ansprüche 1 bis 5, wobei die Zelle eine erste Kontaktaufnahme-Zone (124, 224) auf einer vorderen Fläche der ersten Schicht (109) auf Grundlage von Halbleiter-Material umfasst, auf welcher sich das Elektrolyt befindet, sowie eine zweite Kontaktaufnahme-Zone (122) auf einer hinteren Fläche der Schicht (109) auf Grundlage von Halbleiter-Material, welche dazu vorgesehen ist, einer Lichtstrahlung ausgesetzt zu werden.

**7.** Vorrichtung nach Anspruch 6, wobei die Schicht aus Halbleiter-Material eine hintere Fläche umfasst, auf welcher sich ein durchbrochenes metallisches Element befindet, wobei die zweite Kontaktaufnahme-Zone eine Zone des durchbrochenen metallischen Elements ist.

**8.** Vorrichtung nach einem der Ansprüche 1 bis 7, wobei die Zelle eine Kontaktaufnahme-Zone (226) auf einem Abschnitt der ersten Elektrode (102) umfasst, welcher von der zweiten Elektrode mittels einer Schicht (114) aus dielektrischem Material isoliert ist.

**9.** Vorrichtung nach einem der Ansprüche 1 bis 8, ferner umfassend eine Schaltung, welche ausgestattet ist mit:

     - Mitteln zum Hervorrufen des Ladens der Akkumulatorzelle,
     - Mitteln zum Hervorrufen des Entladens der Akkumulatorzelle,
     - Mittel zum alternativen Versetzen der Zelle in einen Lade- oder Entlade-Zustand.

**10.** Verfahren zum Herstellen einer elektrochemischen Akkumulatorzelle, umfassend das Bilden einer Elektrode der Zelle auf Grundlage von Halbleiter-Material, welches dazu bestimmt ist, wenigstens einen Typ von Ionen abzugeben oder/und anzunehmen, sowie Mittel in dem Halbleiter-Material dieser Elektrode zum Umwandeln von Photonen in Elektronen, wobei das Herstellen der Mittel zum Umwandeln der Photonen in Elektronen das Dotieren einer Region des Halbleiter-Materials mit Ionen von dem Typ von Ionen umfasst.

**11.** Verfahren nach Anspruch 10, wobei das Dotieren mit Hilfe von Li+-Ionen durchgeführt wird.

**12.** Verfahren nach Anspruch 11, wobei das Dotieren durchgeführt wird durch:

- Anlagern einer Schicht von Lithium,
- derartiges thermisches Ausglühen, dass die Li+-Ionen in das Halbleiter-Material diffundieren.

**13.** Verfahren nach Anspruch 12, wobei das Dotieren des Halbleiter-Materials mit Hilfe von Li+-Ionen Schritte umfasst, welche aus einem wiederholten Versetzen der Akkumulatorzelle in einen Lade-Zustand und einen Entlade-Zustand bestehen.

**Claims**

**1.** A device for converting luminous energy into electrical energy and storing electrical energy comprising at least one electrochemical secondary cell, said cell being formed:

- by a first electrode (102) and a second electrode (108), a given species of ions being intended to flow between said electrodes upon charging or discharging the cell,
- by an electrolyte (105) provided between the first electrode and the second electrode (108), the second electrode (108) comprising a layer (109) based on a semi-conductor material including a zone adapted to convert photons into electrons, said layer (109) of semi-conductor material including a first region (111, 211b) doped by ions of said given species of ions.

**2.** The device according to claim 1, wherein the cell is a lithium secondary cell, said first region (111, 211b) being doped by Li+ ions.

**3.** The device according to claim 1 or 2, wherein said layer (109) of semi-conductor material includes a second doped region (112, 212a) facing said first doped region and forms a junction with said doped region.

**4.** The device according to claim 3, wherein said layer (109) of semi-conductor material includes a front face on which the electrolyte (105) lies, said front face being in contact with a third doped region (211a

provided between said front face and said first doped region (211b), said third doped region (211a) having a doping of the same type as that of the first doped region (211b) and a concentration of dopants higher than that of said first doped region (211b).

**5.** The device according to claim 3 or 4, wherein said layer (109) of semi-conductor material includes a back face intended to be exposed to a luminous radiation and which is opposite to a front face on which the electrolyte (105) lies, said back face being in contact with a fourth doped region (212b) provided between said back face and said second doped region (212a), said fourth doped region (212b) having a doping of the same type as that of the second doped region (212a) and a concentration of dopants higher than that of the second doped region (212a).

**6.** The device according to one of claims 1 to 5, wherein the cell comprises a first contacting zone (124, 224) on a front face of said layer (109) based on a semi-conductor material on which the electrolyte lies, and a second contacting zone (122) on a back face of said layer (109) based on a semi-conductor material intended to be exposed to a luminous radiation.

**7.** The device according to claim 6, wherein said layer of semi-conductor material includes a back face on which an apertured metal element lies, said second contacting zone being a zone of said apertured metal element.

**8.** The device according to one of claims 1 to 7, wherein the cell comprises a contacting zone (226) on a portion of the first electrode (102) isolated from the second electrode via a layer (114) of dielectric material.

**9.** The device according to one of claims 1 to 8, further comprising a circuit provided with:

- means for promoting charging of the secondary cell,
- means for promoting discharging of the secondary cell,
- means for alternately placing the cell in a charging or discharging state.

**10.** A method for making an electrochemical secondary cell comprising forming an electrode of the cell based on a semi-conductor material intended to release and/or accept at least one species of ions and means in said semi-conductor material of this electrode to convert photons into electrons, making said means to convert photons into electrons including doping a region of said semi-conductor material by ions of said species of ions.

**11.** The method according to claim 10, wherein said doping is made using Li+ ions.

12. The method according to claim 11, wherein said doping is performed by:

    - depositing a Lithium layer,
    - thermal annealing so as to diffuse Li+ ions in said semi-conductor material.

13. The method according to claim 12, wherein said doping using Li+ ions of said semi-conductor material comprises steps of repeatedly placing the secondary cell in a charging state and in a discharging state.

FIG. 1

FIG. 2A

FIG. 2B

FIG. 2C

FIG. 2D

FIG. 3

FIG. 4

## RÉFÉRENCES CITÉES DANS LA DESCRIPTION

**Documents brevets cités dans la description**

- US 20030127126 A1
- WO 2009032986 A
- US 4481265 A
- US 2009072780 A